# EUROPEAN PATENT APPLICATION

(11) **EP 1 515 359 A1**
(43) Date of publication of application: **16.03.2005**
(21) Application number: 03020774.0
(22) Date of filing: 12.09.2003
(51) Int. Cl.: H01J 37/18, H01J 37/26

(54) **Chamber with low electron stimulated desorption**

(71) Applicant: ICT Integrated Circuit Testing Gesellschaft für Halbleiterprüftechnik mbH, 85551 Heimstetten (DE)
(72) Inventor: Frosien, Jürgen, 85521 Riemerling (DE); Jasinski, Thomas, 81245 München (DE); Winkler, Dieter, 81737 München (DE)
(74) Representative: Zimmermann, Gerd Heinrich

(57) **Abstract**

The present invention provides a charged particle emission component (100) for providing a charged particle beam (17) to a chamber of a charged particle beam column. The device comprises a gun chamber for housing the charged particle emission component; an emitter (16) for emitting a beam of charged particles; at least one beam shaping element (109; 18; 108; 402); and a residual gas diffusion barrier (106; 206) directly subsequent the emitter.

## Description

### FIELD OF THE INVENTION

The invention relates to a charged particle beam device for inspection system applications, testing system applications, lithography system applications, electron microscopes and the like. It also relates to methods of operation thereof. Further, the present invention relates to a charged particle beam device and gun chambers thereof. Specifically, it relates to a charged particle emission components, a charged particle beam device and a method of operating a charged particle beam device.

### BACKGROUND OF THE INVENTION

Charged particle beam apparatuses have many functions, in a plurality of industrial fields, including, but not limited to, inspection of semiconductor devices during manufacturing, exposure systems for lithography, detecting devices and testing systems. Thus, there is a high demand for structuring and inspecting specimens within the micrometer and nanometer scale.

Micrometer and nanometer scale process control, inspection or structuring, is often done with charged particle beams, e.g. electron beams, which are generated and focused in charged particle beam devices, such as electron microscopes or electron beam pattern generators. Charged particle beams offer superior spatial resolution compared to, e.g. photon beams due to their short wavelengths.

Generally, charged particle beam devices are operated under vacuum conditions, still they can create unwanted ions, ionized molecules and other particles in the vacuum chambers. During operation, electrons impinge on component surfaces of the device, like extractors, anodes, apertures or the chamber wall. This can result in a shower of residual gas. If molecules in this shower of residual gas are hit by electrons, ions, ionized molecules and other particles can be created. If the ions and ionized molecules have a charge that is opposite to the charge of the charged particles emitted by an emitter, the ions and ionized molecules in the residual gas are accelerated towards the emitter. As a result, the emitter can be mechanically deformed from the impingement of the ions and ionized molecules or these particles can be deposited on the emitter. Thereby, emitter noise is introduced.

Thus, the vacuum conditions within the charged particle columns of the state of the art devices should be improved.

### SUMMARY OF THE INVENTION

The present invention intends to provide an improved charged particle beam emission component and an improved charged particle beam device. According to aspects of the present invention, a charged particle emission component according to independent claims 1 and 14, a charged particle beam device according to independent claim 18 and a method of operating a charged particle beam device according to independent claim 19 is provided.

According to one aspect, a charged particle emission component for providing a charged particle beam is provided. The device comprises a first UHV region, a second UHV region, and a residual gas diffusion barrier separating the first and the second UHV region. Further, the first UHV region does not comprise elements, which essentially block a portion of the charged particle beam.

Regarding the elements blocking the charged particle beam, the housing of a respective chamber or parts of the chamber is to be also understood as an element that should be avoided to block a portion of the charged particle beam.

Further, the term "essentially" is to be understood so that preferably the elements do not block more than 20 %, more preferably the elements do not block more than 10 % and even more preferably the elements do not block more than 2 % of the charged particle beam.

According to another aspect, a charged particle emission component for providing a charged particle beam is provided. The device comprises a first UHV region, a second UHV region, and a residual gas diffusion barrier separating the first and the second UHV region. Further, the first UHV region does not comprise elements, which essentially block a portion of the charged particle beam and there are at least two vacuum flanges, one for each of the two UHV regions.

According to another aspect, a charged particle emission component is provided. The charged particle emission component generates a charged particle beam to be guided to a further portion of the charged particle beam column. The device comprises a housing of a gun chamber, an emitter for emitting a beam of charged particles, at least one beam shaping element, and a residual gas diffusion barrier, which is -in beam direction- directly subsequent to the emitter. The residual gas diffusion barrier has an opening with a size larger than the size corresponding to the beam emission angle.

Thereby, the term "directly subsequent in beam direction" signifies that the electrons emitted from the emitter tip of an emitter do not pass through another optical component before passing through the opening of the diffusion barrier; unless the diffusion barrier does not act as an extractor or modulator of the field emitter, then the extractor can be located shortly after the emitter tip.

Making use of the above aspects, gas molecules generated by ESD from electrons having passed the residual gas diffusion barrier do not get in the region of the emitter. Thereby, stability of the emitter is improved and damage to the emitter is reduced.

According to a further aspect, a vacuum flange is provided for each of the two UHV regions.

According to a further aspect, the residual gas diffusion barrier has an aperture with a size corresponding to a beam emission angle of minimal 10°. According to an even further aspect, the diameter of the opening in the diffusion barrier is at least 1 mm, preferably at least 3 mm, more preferably at least 5 mm. In view of the above, charged particles do not impinge on the surface of the diffusion barrier and pass through the opening before generating ESD.

According to a further aspect, the residual gas diffusion barrier separates the gun chamber in a first and a second UHV region. Thereby, a first and a second UHV region are generated. Due to separating the regions and avoiding or reducing ESD in the first UHV region, the pressure conditions of the first UHV region including the emitter can be improved. According to an even further aspect, the pressure in the first and the second UHV region or chamber is maximal 10⁻⁸ mbar. Thereby, there is a negligible pressure difference between the first and the second UHV region. Consequently, no laminar gas flow exists between the first and the second UHV region. As an alternative, there may be a pressure difference of maximal one magnitude. This may occur when the gas produced by ESD worsens the vacuum level in the second UHV region. However, due to the small gas load the pressure difference will be limited to one magnitude, which is well below a pressure difference obtained for differential pumping systems as known from the prior art.

According to a further aspect, the emitter is located in the first UHV region, whereas a at least one beam shaping element is located in the second UHV region. According to another aspect the amount of charged particles impinging on surfaces located in the first UHV region is maximal 20 %, preferably maximal 10 % , more preferably maximal 3 % of the amount of charged particles impinging on surfaces located in the gun chamber, that is the first and the second UHV region.

According to another aspect, the beam shaping elements that essentially block a portion of the charged particle beam are only located in the second UHV region. Thus, ESD is partly or totally avoided in the first region.

According to another aspect, a charged particle emission component is provided. The device comprises a first UHV region; a second UHV region; and a residual gas diffusion barrier separating the first and the second UHV region. Thereby, the amount of charged particles impinging on surfaces located in the first UHV region is maximal 20 %, preferably maximal 10 % and more preferably maximal 5 % of the amount of charged particles impinging on surfaces located in the gun region. Alternatively, details described with respect to other aspects above can partly or entirely be included in this aspect.

According to another aspect, a charged particle beam device is provided, which incorporates any of the above mentioned aspects. Thus, the emitter device is used for inspection, testing, lithography or imaging systems.

According to another aspect, a method of operating a charged particle beam column is provided. Thereby, the first UHV region and the second UHV region are evacuated to a pressure of maximal 10⁻⁸ mbar, preferably to a pressure of maximal 10⁻⁹ mbar. There is at least one further chamber which is evacuated to a pressure of maximal 10⁻⁵ mbar. In the case where a differential pumping section is included in the charged particle beam column, the at least one further chamber is evacuated to a pressure of maximal 10⁻⁷ mbar. After reaching the required vacuum level, a charged particle beam is emitted so that essentially no ESD occurs in the first UHV region.

Thereby, the term "essentially" is to be understood so that preferably maximal 20 % of the primary electrons generate ESD, more preferably maximal 10 % of the primary electrons generate ESD, and even more preferably maximal 2 % of the primary electrons generate ESD.

Therefore, according to another aspect, the charged particle beam column is operated so that the amount of charged particles impinging on surfaces located in the first UHV region is maximal 20 % of the amount of charged particles impinging on surfaces located in the gun chamber.

According to a further aspect, a process for manufacturing a charged particle emission component is provided. The process comprises providing a first UHV region, a second UHV region, and a residual gas diffusion barrier separating the first and the second UHV region. Further, the device is provided so that the first UHV region does not comprise elements, which essentially block a portion of the charged particle beam. A vacuum flange for the first UHV region and a vacuum flange for the second UHV region are provided.

According to another aspect, a process of manufacturing a charged particle emission component is provided. Thereby, a housing of a gun chamber, an emitter for emitting a beam of charged particles, at least one beam shaping element, and a residual gas diffusion barrier are provided. The residual gas diffusion barrier is provided to be -in beam direction- directly subsequent to the emitter. The residual gas diffusion barrier is provided with an opening with a size larger than the size corresponding to the beam emission angle.

Thereby, the term "directly subsequent in beam direction" signifies that the electrons emitted from the emitter tip of an emitter do not pass through another optical component before passing through the opening of the diffusion barrier; unless the diffusion barrier does not act as an extractor or modulator of the field emitter, then the extractor can be located shortly after the emitter tip.

The invention is also directed to an apparatus for carrying out the disclosed methods, including apparatus parts for performing each of the described method steps. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus. Yet, the invention is also directed to a process of manufacturing the described apparatuses. It includes process steps for providing every feature of the apparatus.

### BRIEF DESCRIPTION OF THE DRAWINGS

Some of the above indicated and other more detailed aspects of the invention will be described in the following description and partially illustrated with reference to the figures. As used herein, like numerals throughout the various figures represent the same or equivalent features of the present invention. Therein:
- Fig. 1: shows a schematic side view of an embodiment of an emission component with a residual gas diffusion barrier acting as an isolating aperture;
- Fig. 2: shows a schematic side view of an embodiment of an emission component with another residual gas diffusion barrier;
- Fig. 3: shows a schematic side view of an embodiment of an emission component with an einzel lens as a beam shaping element;
- Fig. 4: shows a schematic side view of an embodiment of an emission component with further beams shaping elements;
- Figs.: 5a and 5b show schematic side views of embodiments of an emission component with different vacuum pump connections;
- Fig. 6: shows a schematic side view of an charged particle beam device; and
- Fig. 7: shows a charged particle beam column with a single region gun chamber and a differential pressure chamber included in the charged particle beam column.

### DETAILED DESCRIPTION OF THE DRAWINGS

Without limiting the scope of protection of the present application, in the following, the charged particle beam device will exemplarily be referred to as an electron beam device. Thereby, the electron beam device might especially be an electron beam inspection or lithography system. The present invention can still be applied for apparatuses using other sources of charged particles and/or other secondary and/or backscattered charged particles to obtain a specimen image.

Those skilled in the art would also appreciate that all discussions herein, which relate to vacuums, refer to a higher or better vacuum if the pressure is reduced. Thus, the higher the vacuum is, the smaller the pressure is.

As describe previously, the so-called electron stimulated desorption (ESD) from the surfaces in the vacuum chambers can be considered disadvantageous. This is especially true for the gun chamber, wherein the emitter gun is located. For example, a cold field emitter requires a pressure of about 5*10⁻¹⁰ mbar for stable operation.

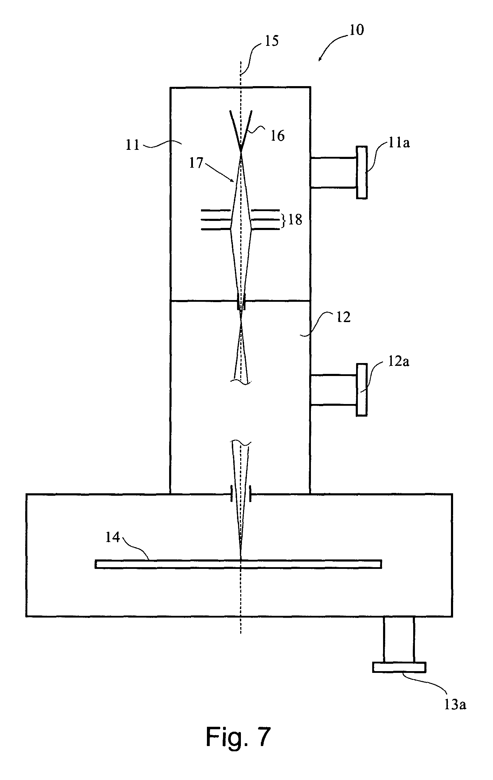

Fig. 7 shows a charge particle beam device 10. The device has a gun chamber 11, an intermediate differential pumping chamber 12, and a specimen chamber 13. Each of these chambers have a vacuum flange 11a, 12a, and 13a, respectively.

Specimen 14 is located in the specimen chamber. The electron beam 17, emitted by emitter 16 along the optical axis 15, is guided onto the specimen. Electrostatic lens 18 is located in the gun chamber 11. Lens 18, comprises three lens elements and focuses the electron beam 17. A part of said electron beam 17 is blocked by the top lens element, which also acts as an anode. Thus, some of the electrons impinge on a component, e.g. the anode, located in the gun chamber 11. Thereby, gas molecules are desorbed from the surface of this component. As a result, the ultra-high vacuum (UHV) of for example 5*10⁻¹⁰ mbar is deteriorated and, as explained above, the stability of the emitter 16 is reduced or the emitter 16 can be damaged.

In order not to further decrease the pressure in the gun chamber 11 by molecules entering the gun chamber from the specimen chamber 13, an intermediate chamber 12 is introduced. Intermediate chamber 12 can also be used to house other beam guiding elements like deflectors or lenses.

Nevertheless, using an intermediate chamber 12 increases the length of the entire optical column, which in turn is a source for instability, increase in production costs, and less favorable optical design. Thus, a further improvement, which is described in the following, is desirable.

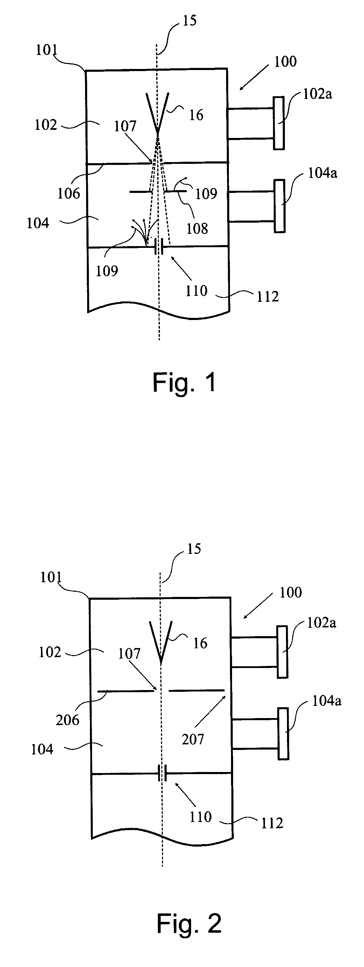

Fig. 1 shows one embodiment of an emitter device 100. The device has a gun chamber housing 101. The gun chamber has two separate areas, the first UHV region 102 and the second UHV region 104. The two regionss are separated by a residual gas diffusion barrier 106. Both regions 102 and 104, respectively, have a vacuum flange 102a and 104a. Thereby, ultra-high vacuum can be provided in the regions 102 and 104. The gun chamber is separated to the further chamber 112 by a differential pressure aperture 110.

The components of the emission device 100 are described below. The emitter 16, a cold field emitter, emits the electrons along the optical axis 15. Thereby, the electron beam emission angle is about 5°. The opening 107 of the residual gas diffusion barrier 106 is sized such that essentially no electrons impinge on surfaces of this component. Thus, the electrons pass to the second UHV region 104 without any electron stimulated desorption (ESD). All components that shape or manipulate the electron beam 17 are located in the second UHV region, so that electrons can impinge on surfaces thereof.

In Fig. 1, an anode 108 accelerates the electron and blocks a portion of the emitted electron beam 17. As indicated by the arrows 109, gas molecules are desorbed by the surface of anode 108. Thereby, the ultra-high vacuum within the gun chamber is deteriorated. However, due to the residual gas diffusion barrier 106, molecules cannot diffuse into the first UHV chamber 102. Consequently, the vacuum therein is not deteriorated and possible damage or instability of emitter 16 is reduced.

After the electron beam has passed through anode 108, a portion of the electrons also hits the disk element of the differential pressure aperture 110. Again, the molecules desorbed within the gun chamber 11 do not enter the first UHV chamber 102.

Thus, components having surfaces whereon electrons impinge for beam shaping or other reasons are located within the second UHV region, whereas the emitter is located in the first UHV region.

In the following, figures 2 to 6 will be described with reference to Fig. 1. Thus, only the differences with respect to Fig. 1 are described.

Fig. 2 shows an embodiment with a modified residual gas diffusion barrier 206. Generally, both UHV regions 102 and 104 have, during operation, a vacuum with a pressure of maximal 10⁻⁸ mbar. Although, ESD only occurs in the second UHV region and, thus, only the vacuum in the second UHV region is deteriorated, both regions have a pressure of for example essentially 5*10⁻¹⁰ mbar. The gas load in the second UHV region, which is introduced by ESD, is small enough to be pumped out of the region. Therefore, both regions maintain essentially the same pressure.

Consequently, it is not necessary to isolate the two vacuum regions as it is done with a differential pressure aperture between two chambers having significantly different pressures (e.g. two orders of magnitude). Therefore, the residual gas diffusion barrier 206 has a central opening 107 and on both sides openings 207 towards the gun chamber's wall. This is sufficient since the diffusion barrier only needs to prevent the diffusion of gas molecules into the first UHV region 102.

Nevertheless, it is also possible that the electron stimulated desorption leads to a comparable small pressure difference between the two UHV regions of e.g. one magnitude. Thereby, for example, the first UHV region has a pressure of 10⁻¹⁰ mbar and the second UHV region has a pressure of 10⁻⁹ mbar. In such a case, it would be preferred to use a residual gas diffusion barrier 106, as disclosed in Fig. 1. In the case of the pressure difference of one magnitude, the residual gas diffusion barrier 106 acts as an isolating aperture. Further, the two UHV regions could be considered to be UHV chambers. However, it still has to be distinguished to a differential pressure aperture. A differential pressure aperture usually is formed such that a pressure difference of at least two magnitudes can be obtained between the two separated chambers.

In the embodiment of Fig. 2, the residual gas diffusion barrier 206 simultaneously acts as an extraction electrode. Independent of the individual embodiments described with respect to the figures, the diffusion barrier can for all embodiments act as an extraction electrode or any other electrode to modulate or extract the electrons from the emitter 16. However, the opening 107 of the residual gas diffusion barrier, whether acting as an electrode or not, has to be sized such that no electrons impinge on the surface thereof. Thereby, generally, the opening 107 has a diameter of at least 1.5 mm and/or has a size corresponding to a beam emission angle of at least 10°.

However, the size of opening 107 depends on the corresponding beam emission angle and the distance from e.g. the emitter. This will be explained with the following example. Presume the distance of the opening from the emitter is to be 1 mm and the beam emission angle 5°. Within the present application, the beam emission angle is defined as the angle between the periphery of the emission cone and the center of the emission cone. Thus, the minimal radius of a corresponding opening will be about 87 µm and the diameter of the opening will, consequently, be about 175 µm. Therefore, also smaller diameters can be used. As explained above, this depends on the distance of the residual gas diffusion barrier from the emission position.

In the present application it is referred to the fact that the residual gas diffusion barrier would be - in beam direction - directly subsequent to the emitter. In the case of a cold field emitter this is the case if the residual gas diffusion barrier acts as the extractor or modulator. If an extractor exists independently of the residual gas diffusion barrier and if the opening for the charged particles of the extractor is large enough not to produce an ESD, this extractor can be located in the first UHV region. Thus, within the wording of this application, the extractor would, if separate from the residual gas diffusion barrier, be considered a part of the emitter.

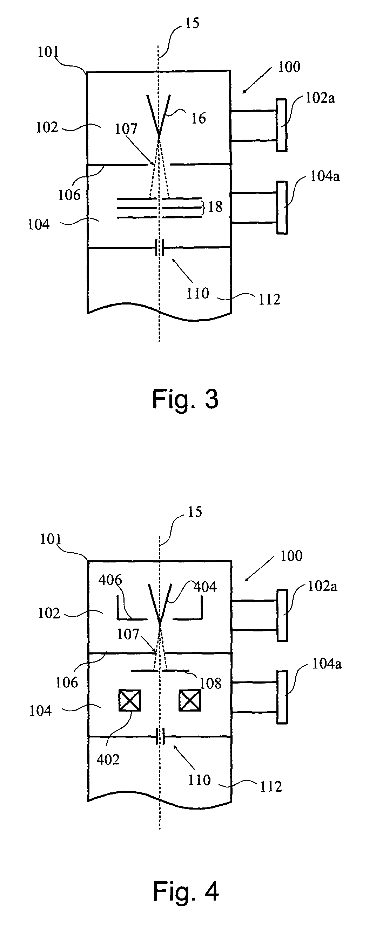

A further embodiment will now be described with respect to Fig. 3. The electron emission device 100 of Fig. 3 also has a residual gas diffusion barrier (or isolating aperture) 106 and two separate regions, namely the first UHV chamber 102 and the second UHV region 104. The second UHV chamber, and thereby the entire gun chamber, is separated to a further chamber 112 by the differential pressure aperture 110. Both UHV chambers have a vacuum flange 102a, 104a.

The beam-shaping element located within the second UHV chamber 104 in Fig. 3 is an electrostatic lens 18. The electrostatic lens 18 comprises three lens elements. The electrons emitted by emitter 16 impinge on the first of the three elements. As already described with respect to Fig. 1, gas molecules are desorbed, which worsens the vacuum conditions in the second UHV chamber. However, gases produced by ESD are pumped out of the second UHV chamber and, thus, do not influence the emission properties of emitter 16.

Fig. 4 shows another embodiment. In this embodiment, the emitter is not a cold field emitter, but the Shottky emitter heated to several hundred degrees Celsius. To suppress the emission of thermionic electrons, suppressor 406 is provided. Even though, suppressor 406 is located in the first UHV chamber, no electrons can impinge on the surface thereof since the tip of emitter 404 is located below the suppressor. Thus, even though, a further component is located in the first UHV chamber, the residual gas diffusion barrier is - in beam direction - directly subsequent to the emitter. Since the residual gas diffusion barrier 106 is subsequent to the emitter, the advantages described with respect to the embodiments above also apply to this embodiment.

However, some emitter arrangements have a suppressor being located shortly after the emitter tip. In the present application it is referred to the fact that the residual gas diffusion barrier would be - in beam direction - directly subsequent to the emitter. If a suppressor exists and if the suppressor is formed so as not to produce an ESD, this suppressor can be, located in the first UHV chamber. Thus, within the wording of this application, an accordingly formed suppressor would, if present, be considered a part of the emitter.

Another difference between Fig. 4 and Fig. 1 is the magnetic condenser lens 402 and the anode 108 located in the second UHV region 104. This is to be understood as a further example to be combined with any disclosed embodiment. Generally, there are several possibilities to have beam shaping elements in the gun chamber. Yet, surfaces on which ESD can occur should mostly be located in the second UHV region 104. However, it is well within the scope of the invention, if e.g. at least 80 % of the surfaces are located within the second UHV region.

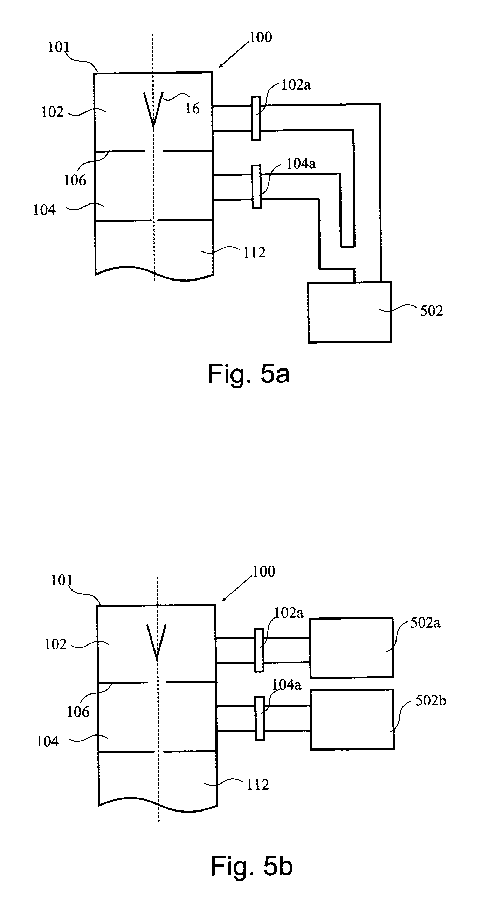

Figures 5a and 5b refer to the aspect of evacuation of the gun chamber 11. Within Fig. 5a a first embodiment is shown. Thereby, the first UHV region 102 has a vacuum flange 102a and the second UHV region 104 has a vacuum flange 104a. Both are connected to one vacuum pump 502. This pump for generation of a pressure of e.g. 10⁻¹⁰ mbar can be an ion getter pump or a NEG-pump (non evaporable getter pump). The bellows connecting both vacuum flanges 102a, 104a to the pump join at a tee. Even though, the two UHV regions are connected, molecules cannot diffuse from the second region to the first region even if there might be a small pressure difference. This difference is small enough that there will be no laminar flow into the first UHV region 102. Thus, the bellows provide sufficient resistance with regard to the diffusion of gas molecules.

According to another embodiment shown in Fig. 5b, each of the UHV regions 102 and 104 is connected to its own vacuum pump. Each of the two pumps 502a and 502b can be of the same type as described with respect to Fig. 5a. Providing two separate pumps increases the number of components that have to be provided in the vicinity of the electron beam column. However, any possible impact of one UHV region on the other is reduced.

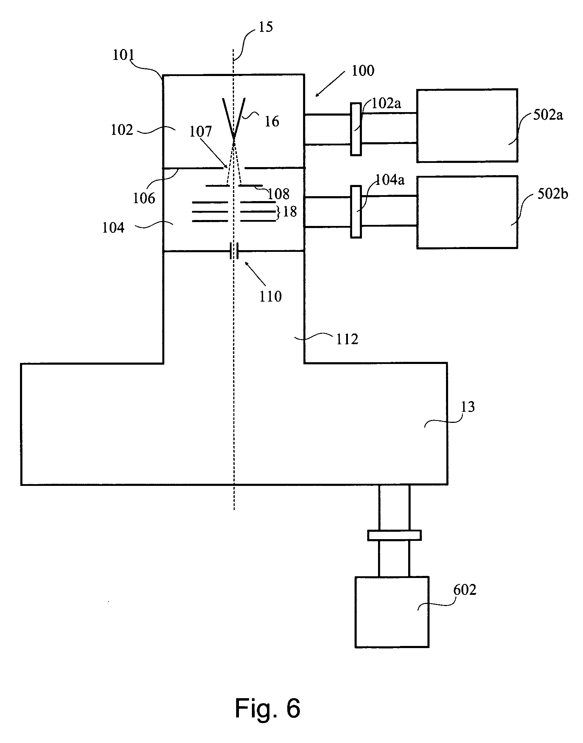

The embodiments described with respect to Fig. 1 to Fig. 5b have, for example, different residual gas diffusion barriers 106,206; the residual gas diffusion barriers act as extraction electrodes and/or isolating apertures; the embodiments have different forms of beam shaping components located in the second UHV region and further, different types of emitters are shown. Beyond that, variations regarding the connections to vacuum pumps have been described. Unless they are mutually exclusive, different aspects of these embodiments can be combined with each other. In order to give one example, Fig. 6 will be described below.

Fig. 6 shows a charge particle beam device with a specimen chamber 13, which is evacuated by a pump 602. Pump 602 is for example a turbo pump. The electron beam 17, used to inspect or to pattern a specimen, which is located in the specimen chamber 13, is generated within the emission component 100. Emission component 100 is separated into the first UHV region 102 and the second UHV region 104. The separating element is the residual gas diffusion barrier 106 with the opening 107. As explained previously, the opening is sized so that essentially no electrons impinge on the diffusion barrier. Nevertheless, the residual gas diffusion barrier (isolating aperture) 106 is charged to a potential such that electrons from the emitter 16 are extracted or modulated.

Emitter 16 is located in the first UHV region. Contrary thereto, all other beam shaping elements, blocking a portion of the electron beam 17, are located in the second UHV region. These elements are the anode 108 and the electrostatic lens 18.

The first UHV region 102 and the second UHV region 104 each have a vacuum flange 102a and 104a, respectively. Ion getter pumps 502a and 502b are connected to the respective ports. Thus, an ultra-high vacuum within the range of the magnitude of 10⁻¹⁰ mbar can be achieved in both UHV regions 102 and 104. The gas load generated due to ESD is low. Therefore, the pressure change in the second region and the resulting pressure difference between the two regions can be neglected.

The residual gas diffusion barrier 106 prevents gas molecules from entering the first UHV region. As a result, stable operation of the emitter and reduced damage to the emitter 16, can be achieved during operation.

Independent of specific embodiments, without limiting the invention thereto, the following aspects might also be considered.

According to one aspect, the device has a differential pressure aperture between the gun chamber and a further chamber. Thereby, ultra-high vacuum can be realized in the gun chamber.

According to another aspect, the residual gas diffusion barrier acts as an extraction electrode for extracting or modulating the charged particles emitted from the emitter. However, it is sized so as not to block a portion of the electron beam or to be hit by electrons for other reasons.

Contrary to the size of the residual gas diffusion barrier, according to a further aspect, generally, the beam shaping elements located in the second UHV region can block a portion of the charged particle beam by e.g. having an aperture with a size corresponding to a beam emission angle of maximal 1°.

According to an even further aspect, the first and the second UHV region each have a vacuum flange. Thereby, the first vacuum flange corresponding to the first UHV region and the second vacuum flange corresponding to the second UHV region are both connected to one vacuum pump. As an alternative, the first vacuum flange corresponding to the first UHV region and the second vacuum flange corresponding to the second UHV region are connected to separate vacuum pumps. These pumps can be any one or any combination of the following pump: an ion getter pump, a non evaporable getter pump or the like.

In view of the above, according to one example, the surfaces of the first UHV chamber, which could possibly be hit by electrons stimulating desorption, are the surfaces of at least one of the following components: an emitter, the residual gas diffusion barrier, and the part of a gun chamber wall corresponding to the first UHV chamber; whereas the surfaces of the second UHV chamber are the surfaces of at least one of the following components: at least one beam shaping element, a differential pressure aperture, and the part of a gun chamber wall corresponding to the second UHV chamber.

## Claims

1. Charged particle emission component for providing a charged particle beam, comprising:
a first UHV region (102);
a second UHV region (104); and
a residual gas diffusion barrier (106; 206) separating the first and the second UHV region;
whereby the first UHV region does not comprise elements, which essentially block a portion of the charged particle beam; and
wherein the first and the second UHV region (102, 104) each have a vacuum flange (102a, 104a).

2. Charged particle emission component according to claim 1, further comprising an emitter (16) in the first UHV region for emitting the beam of charged particles (17).

3. Charged particle emission component according to any of the preceding claims, further comprising an aperture unit (110) for differential pumping between the emission component and a further chamber (112) of a charged particle beam column.

4. Charged particle emission component according to any of the preceding claims, whereby the residual gas diffusion barrier has an opening (107) with a diameter larger than the diameter corresponding to the beam emission angle; preferably with a diameter corresponding to a beam emission angle of minimal 10°.

5. Charged particle emission component according to any of the preceding claims, wherein the residual gas diffusion barrier (106; 206) has an opening (107) for the charged particle beam, the opening has a size of at least 1 mm, preferably of at least above 5mm.

6. Charged particle emission component according to any of the preceding claims, wherein the residual gas diffusion barrier acts (106; 206) as an extraction electrode for extracting or modulating the emitted charged particles.

7. Charged particle emission component according to any of the preceding claims, further comprising at least one beam shaping element (109; 18; 108; 402) in the second UHV region (104), wherein the at least one beam shaping element blocks a portion of the charged particle beam by having an opening for the charged particle beam, the opening has a size corresponding to a beam emission angle of below 5°, preferably of below 1°.

8. Charged particle emission component according to any of the preceding claims 7, wherein the first and the second UHV region have in operation a pressure of maximal 10⁻⁸ mbar.

9. Charged particle emission component according to any of the preceding claims, wherein the first and the second UHV region have in operation a pressure difference of maximal one magnitude.

10. Charged particle emission component according to any of the preceding claims, wherein the amount of charged particles impinging on surfaces located in the first UHV region is maximal 20 % of the amount of charged particles impinging on surfaces located in the emission component.

11. Charged particle emission component according to any of the preceding claims, wherein the first vacuum flange (102a) corresponding to the first UHV region (102) and the second vacuum flange (104a) corresponding to the second UHV region (104) are connected to one vacuum pump (502).

12. Charged particle emission component according to any of the preceding claims, wherein the first vacuum flange corresponding to the first UHV region and the second vacuum flange corresponding to the second UHV region are connected to separate vacuum pumps (502a, 502b).

13. Charged particle emission component according to any of the preceding claims, wherein the residual gas diffusion barrier is an isolating aperture and the first and the second UHV regions are UHV chambers.

14. Charged particle emission component for providing a charged particle beam, comprising:
a housing (101) of the charged particle emission component;
an emitter (16) for emitting a beam of charged particles (17) with a beam emission angle;
at least one beam shaping element (109; 18; 108; 402); and
a residual gas diffusion barrier (106; 206) directly subsequent to the emitter, whereby the residual gas diffusion barrier separates the charged particle emission component in a first and a second UHV region,
whereby the residual gas diffusion barrier has an opening (107) with a diameter larger than the diameter corresponding to the beam emission angle; and
wherein the first and the second UHV region (102, 104) each have a vacuum flange (102a, 104a).

15. Charged particle emission component according to claim 14, whereby the first UHV region does not comprise elements, which essentially block a portion of the charged particle beam.

16. Charged particle emission component according to any of claims 14 to 15, further comprising any of the features of claims 1 to 13.

17. Charged particle emission component according to any of claims 1 to 16, wherein the surfaces of the first UHV region are the surfaces of at least the following components:
the emitter (16),
the residual gas diffusion barrier,
the part of the emission component housing (101) corresponding
to the first UHV region, and
and wherein the surfaces of the second UHV region are the surfaces of at least the following components:
the at least one beam shaping element,
the differential pumping aperture (109; 18; 108; 402),
the part of an emission component housing corresponding to the second UHV region.

18. Charged particle beam device making use of a charged particle emission component according to any of the preceding claims.

19. Method of operating a charged particle beam device, comprising the steps of:
evacuating a first UHV region to a pressure of maximal 10⁻⁸ mbar;
evacuating a second UHV region to a pressure of maximal 10⁻⁸ mbar;
evacuating at least a further chamber to a pressure of maximal 10⁻⁵ mbar; and
emitting a charged particle beam such that a portion of the charged particle beam is essentially not blocked within the first UHV region.

20. Method of operating a charged particle beam device according to claim 19, whereby
the charged particles are emitted with an emission angle such that the amount of charged particles impinging on surfaces located in the first UHV region is maximal 20 % of the amount of charged particles impinging on surfaces located in the first and the second UHV region.

21. Method of operating a charged particle beam device according to any of claims 19 to 20, whereby
a portion of the beam is blocked in the second UHV region, such that the beam is shaped.
